(19) Europäisches Patentamt
European Patent Office
Office européen des brevets

(11) **EP 2 797 237 A1**

(12) **EUROPEAN PATENT APPLICATION**

(43) Date of publication:
**29.10.2014 Bulletin 2014/44**

(51) Int Cl.:
***H03M 13/39*** (2006.01)   ***H03M 13/41*** (2006.01)
***H03M 13/00*** (2006.01)

(21) Application number: **13187211.1**

(22) Date of filing: **03.10.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **24.04.2013 US 201313869187**

(71) Applicant: **LSI Corporation**
**Milpitas, CA 95035 (US)**

(72) Inventors:
• **Sokolov, Andrey P.**
**Moscow (RU)**

• **Panteleev, Pavel A.**
**Moscow Oblast (RU)**
• **Gasanov, Elyar E.**
**Moscow (RU)**
• **Neznanov, Ilya V.**
**Moscow (RU)**
• **Shutkin, Yurii S.**
**Moscow region (RU)**

(74) Representative: **Williams, David John**
**Page White & Farrer**
**Bedford House**
**John Street**
**London**
**WC1N 2BF (GB)**

(54) **High speed add-compare-select circuit**

(57)   Trellis decoder and decoding method for Viterbi or Log-MAP decoding comprising a radix four, eight or sixteen add-compare-select (ACS) circuit including at least two ACS layer modules (302, 304) coupled in series for iteratively generating new state metrics (q(t+1), q(t+2)) from old state metrics (q(t)) and branch metrics (x(t), x(t+1)), the ACS circuit further including a feedback register (306) for storing state metrics, wherein the ACS layer modules are configured to operate according to carry-save arithmetic, the feedback register (306) is configured to store carry components of the state metrics, and wherein plurality of multiplexers are configured to perform a selection of a maximum state metric in carry-save arithmetic.

**FIG. 3**

**Description**

BACKGROUND OF THE INVENTION

Field of the Invention
The present invention relates to decoder circuitry, and, in particular, to a high speed add-compare-select (ACS) circuit useful in Viterbi and log-maximum a posteriori (log-MAP) decoders for decoding turbo and low-density parity-check codes (LDPC-codes).
Description of the Related Art
ACS units are core elements of Viterbi, turbo and log-MAP decoders. The manner in which ACS units are connected between themselves is defined by a specific code's trellis diagram. ACS operation is a bottleneck arithmetic operation for such trellis based decoding algorithms as Viterbi and log-MAP. These algorithms are extensively used for decoding of the convolutional, turbo and LDPC-codes. Viterbi and log-MAP algorithms are organized in such a manner that if these algorithms are implemented in hardware, then each ACS operation appears on a critical path of of the corresponding Viterbi and/or log-MAP algorithm implementation. The ACS operation determines a depth of the algorithm and corresponding a maximum operating frequency of the decoder.
The decoding process of a generic trellis-based decoding algorithm is typically an iterative process. Each iteration is processed on a single layer of the trellis. The total number of trellis layers is generally equal to a codeword length. A computational procedure that is performed for every trellis layer includes two steps: (i) branch metrics calculation and (ii) state metrics calculation. These two steps are common either for Viterbi or for log-MAP algorithms. Because branch metrics calculation doesn't reside on the critical path of the hardware implementation of the decoder, branch metrics calculation can be pipelined over trellis layers. In contrary, state metrics calculation includes an internal loop back structure. Results of the next iteration essentially depend on the results of the previous iteration for the state metrics calculation. Thus, the state metrics calculation resides on the critical path of the decoder and consequently **determines** maximum possible operating frequency of a whole design of the decoder.

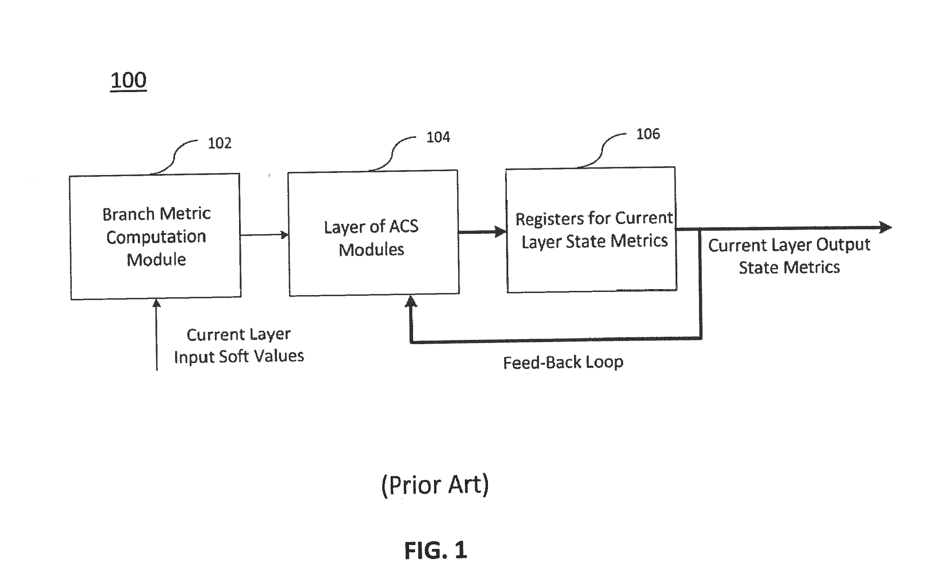

FIG. 1 shows an exemplary conventional trellis based decoder where computations are performed on each layer. As shown, decoder **100** includes branch metric computation module **102,** ACS module **104** and registers **106** for current layer state metrics. Branch metric computation module **102** calculates the branch metrics. ACS module **104** recursively accumulates the branch metrics as the path metrics with a feed-back loop, compares the incoming path metrics, and makes a decision to select the most likely state transitions for each state of the trellis and generates the corresponding decision bits. Registers 106 store the decision bits and help to generate the decoded output. The major arithmetic operation performed during state metrics calculation is the ACS operation.

SUMMARY OF THE INVENTION

In one embodiment, the present invention is a method of iteratively performing an add-compare-selection (ACS) operation. The method includes, for an iteration, providing at least two state metrics with carry-save arithmetic to a first ACS layer module having first respective sum components, producing, by the first ACS layer module, a first set of at least two computing state metrics in carry-save arithmetic in response to a first set of at least two respective branch metrics in a single clock cycle, applying the first set of at least two computing state metrics to a second ACS layer module having second respective sum and carry components, producing, by the second ACS layer module, a second set of at least two computing state metrics in carry-save arithmetic in response to a second set of at least two respective branch metrics and the first set of at least two computing state metrics in the clock cycle, storing the second set of at least another two computing state metrics as carry components of the second ACS layer module, and providing the second set of at least two computing state metrics to the first ACS layer module for a next iteration.
In another embodiment, the present invention is an apparatus for performing an add-compare-select (ACS) operation including at least two ACS layers coupled in series configured to form an iterative loop with carry components in a single clock cycle, wherein the ACS layer includes at least two branch metrics represented by a plurality of bits and adders and configured to i) generate a plurality of state metrics in accordance with carry-save arithmetic, and a plurality of multiplexers and ii) perform a selection of a maximum state metric in carry-save arithmetic which are stored in the carry components.
In another embodiment, the present invention is an apparatus for performing an add-compare-select (ACS) operation including at least two layers of an ACS module configured to perform state metric computations using carry-save arithmetic, each having corresponding input and output states and corresponding input and output vectors, and carry components of stored state metrics, wherein the output state of a preceding layer of the ACS module is provided to a subsequent layer of the ACS module having an input vector different from the input vector of the preceding layer of the ACS module, the apparatus configured to form a ACS layer computing in a single clock cycle to generate at least a maximum state metric in carry-save arithmetic.

In another embodiment, the present invention is a trellis decoder including a memory including a set of registers, and an add-compare-select (ACS) module including at least two ACS layer modules coupled in series and configured to form a feedback loop with carry components in a single clock cycle, wherein the ACS layer module includes at least two branch metrics represented by a plurality of bits and adders configured to generate a plurality of state metrics using carry-save arithmetic, and a plurality of multiplexers configured to perform a selection of a maximum state metric in carry-save arithmetic stored in memory as the carry components.

BRIEF DESCRIPTION OF THE DRAWINGS

Other aspects, features, and advantages of the present invention will become more fully apparent from the following detailed description, the appended claims, and the accompanying drawings in which like reference numerals identify similar or identical elements.

FIG. 1 is an exemplary conventional trellis based decoder;

FIG. 2 is a block diagram illustrating a single standard ACS layer according to the present invention;

FIG. 3 is a block diagram illustrating an embodiment of an ACS speed double technique according to the present invention.

FIG. 4A is a block diagram illustrating a module for an ACS operation of two operands according to the present invention;

FIG. 4B is a block diagram illustrating a standard implementation of an ACS module of two 4-bit operands according to the present invention;

FIG. 5A is a block diagram illustrating a 2 bit ripple carry adder according to the present invention;

FIG. 5B is a block diagram illustrating a standard carry-save adder according to the present invention;

FIG. 6 is a block diagram illustrating an embodiment of a bit-level view of carry-save ACS module of two 4-bit operands according to the present invention;

FIG. 7A is a block diagram illustrating an exemplary embodiment of a turbo decoder for use in accordance with the present invention;

FIG. 7B is a block diagram illustrates an exemplary embodiment of a trellis based decoder applying the ACS double-speed technique in accordance with the present invention; and

FIG. 8 is a flowchart illustrating an exemplary method for the double speed ACS technique shown in FIG. 3 and FIG. 6.

DETAILED DESCRIPTION

Described embodiments of the present invention relate to a high speed ACS circuit useful in Viterbi and log-MAP decoders for decoding turbo and LDPC-codes. A set of schemes for high speed computation of ACS operation in accordance with exemplary embodiments of the present invention are developed for 2 and more trellis layers on a clock cycle. The described embodiments below are examples for 2 trellis layers. These examples, however, might be easily adapted for 3 trellis layers and more. The developed schemes might use carry-save arithmetic computations which might provide a specific structure of the ACS circuit. This feature might make it possible to recognize an inprintment of designs of the ACS circuit. In addition, the developed schemes might contain two or more identical combinatorial ACS layer submodules which might help to recognize the inprintment of these designs and further increase the calculation speed.

Hereinafter, embodiments of the present invention are described with reference to the drawings.

Note that herein, the terms "ACS design", "ACS scheme", "ACS circuit", "ACS module", "ACS layer", "ACS technique" and "ACS operation" might be used interchangeably. It is understood that an ACS design might correspond to, or contain an ACS scheme of, and ACS module, an ACS circuit and an ACS operation, and that the ACS scheme, the ACS module, the ACS layer, the ACS circuit, the ACS technique and the ACS operation might refer to the ACS design.

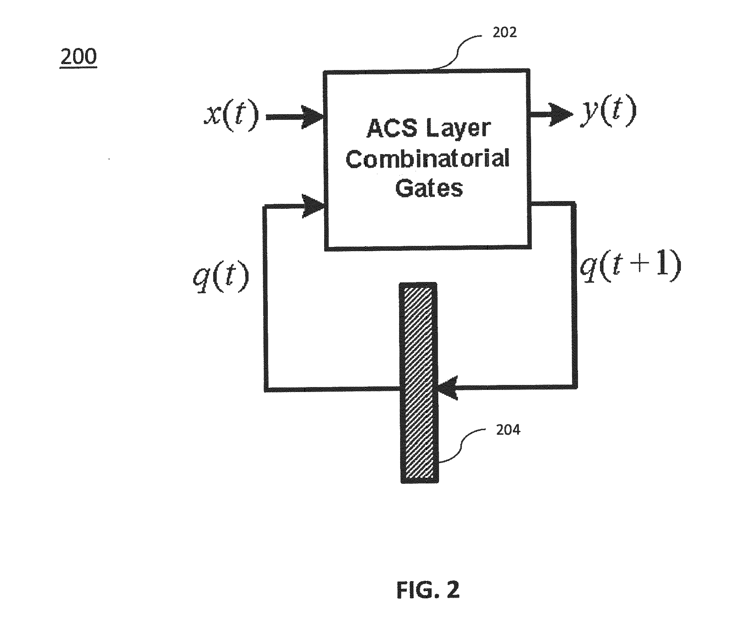

Referring to FIG. 2, a block diagram illustrating a single standard ACS module 200 with computation for an iteration. Standard ACS module **200** includes ACS layer **202**, which might comprise a set of combinatorial gates, and registers **204** coupled to form a loop for an iteration. ACS layer **202** has input vector x(t) and output vector $y(t)$ of an ACS layer computation combinatorial part. Current and next states of standard ACS module **200** are denoted as $q(t)$ and $q(t+1)$. Registers **204** store the state $q(t+1)$ computed from ACS layer **202** and feedback the computed state $q(t+1)$ to ACS layer **202** as the next input state for the next iteration computation. ACS module **200** performs one calculation on single standard ACS layer **202** on a single clock cycle.

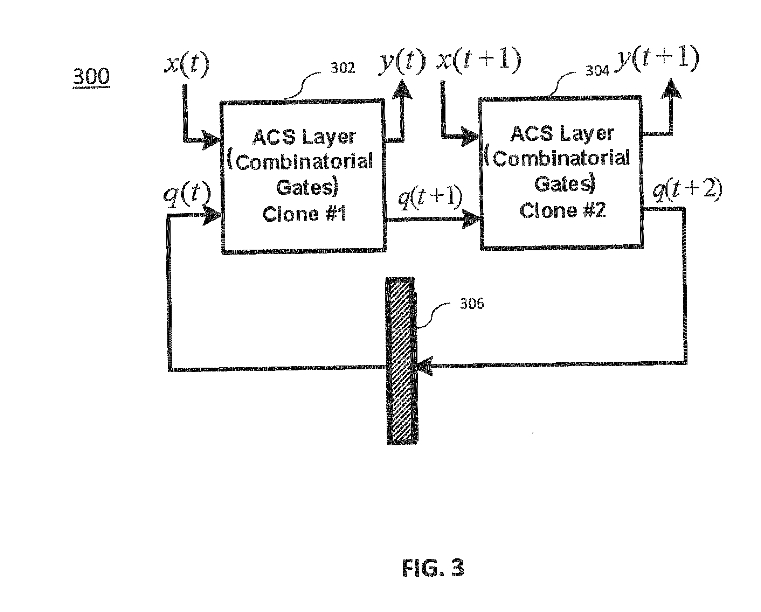

FIG. 3 is a block diagram illustrating an exemplary embodiment of a double speed ACS module **300** that provides for a ACS speed-doubling technique in accordance with an exemplary embodiment of the present invention. The ACS speed-doubling technique herein might be a technique that clones twice or more substantially all combinatorial gates of an ACS module, whereas register requirements are maintained so as to stay unchanged. As shown in FIG. 3, double speed ACS module **300** includes first ACS layer **302**, second ACS layer **304** and registers **306**, which are coupled to form a loop for an iteration. First ACS layer **302** might receive the same input vector $x(t)$ as ACS module **200** shown in FIG. 2, but the output $y(t)$ of first ACS layer **302** might be applied to second ACS layer **304,** which also might receive the next input vector $x(t+1)$. The computed state $q(t+1)$ from first ACS layer **302** might be provided to second ACS layer **304** as an input state. Second ACS layer **304** might output the second output vector $y(t+1)$ and save the computed state $q(t+2)$ into registers **306.** Current and next states of the ACS algorithm might be denoted as $q(t)$, $q(t+1)$ and $q(t+2)$. Registers **306** might store the computed state $q(t+2)$ from second ACS layer **304** and provide the computed state $q(t+2)$ to first ACS layer **302** as the input state $q(t)$ for the next computation. Thus, double speed ACS module **300** might perform calculations on two ACS layers on a single clock cycle whereas standard ACS module **200** might perform calculations on two ACS layers for two clock cycles. Accordingly, the ACS speed double technique of the present invention might increase the speed of calculations through ACS layers.

Furthermore, in the described embodiments, carry-save arithmetic might be employed in the combinatorial part of ACS layers, which might enable a deep optimization of the ACS design with doubled combinatorial part in terms of maximal operating frequency. Thus, doubled ACS design might perform on frequencies higher than half of the working frequency of the standard ACS design. For example, a simulation of a standard ACS layer is successfully closed at 1000MHz and a simulation of an ACS layer with double speed is closed at 650MHz. First and second layers **302, 304** of double speed ACS module **300** with carry-save arithmetic are described subsequently below in detail.

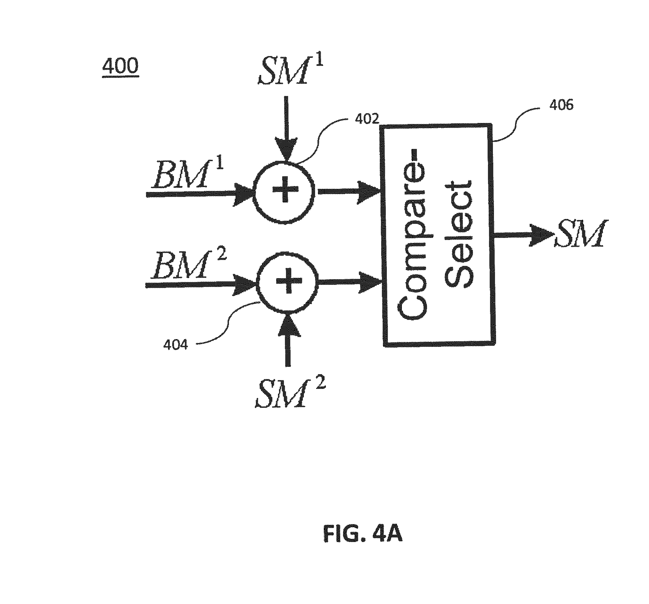

FIG. 4A shows a block diagram illustrating a module for an ACS operation of two operands. As shown, module **400** includes adders **402, 404** for branch metrics $BM^1$ and $BM^2$ and compare-select circuit **406.** Here, $BM$ stands for branch metric and $SM$ for state metric. Module **400** might compute each $SM$ required for a next iteration according to the following relation (1):

$$SM = \max\left(BM^1 + SM^1, BM^2 + SM^2\right) \qquad (1)$$

where "max" denotes a maximum operation.

In some modifications of Viterbi or log-MAP algorithms, a minimum operation might be performed, for example, in relation (1) instead of a maximum operation. However, such modifications generally do not change the design of an ACS significantly. Consequently, one skilled in the art might readily extend the teachings of embodiments of the present invention described herein to embodiments for the minimum operation case(s). The total depth of the scheme might be a depth of an adder (adder **402** or **404**) plus a depth of compare-select circuit **406,** which might be approximately the depth of the adder for a corresponding number of arguments. Thus, a total depth of a given ACS design might significantly depend on the number of its arguments. In general, the number of arguments of the ACS operation is typically equivalent to the number of states in the trellis layer of the ACS module. Generally, an ACS operation of four operands (ACS4), an ACS operation of eight operands (ACS8) and an ACS operation of sixteen operands (ACS16) are usually employed in modern trellis decoders. Accordingly, ACS operation of four operands (ACS4), ACS operation of eight operands (ACS8) and ACS operation of sixteen operands (ACS16) might be applied to the disclosed embodiments.

Since module **400** only includes adders **402, 404** and compare-select circuit **406,** as shown in FIG. 4A, the ACS operation might be relatively simple. However, the simple ACS operation might be difficult to modify to make an ACS algorithm perform faster. However, register-transfer level (RTL) synthesis implements this efficiently, allowing for acceleration using a bit-level implementation.

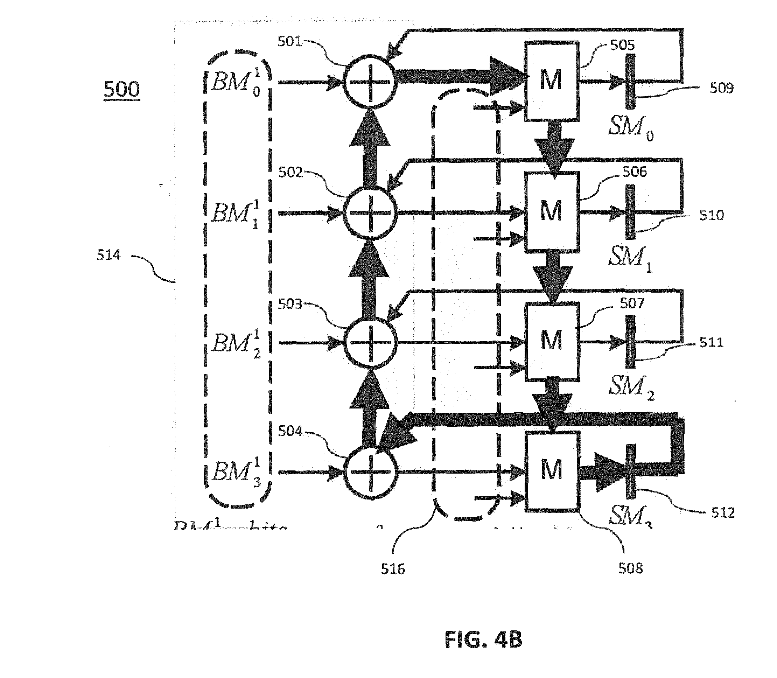

FIG. 4B is a block diagram for a standard implementation of an ACS module of two 4-bit operands. As shown, ACS module **500** includes first and second branch metrics **514, 516** (represented as bit arrays), an array of multiplexers **505, 506, 507, 508,** and an array of registers **509, 510, 511, 512** for storing state metric bits. First branch metric **514** includes branch metric bit array **515** and an array of adders **501, 502, 503, 504.** Bits and adders are shown for first branch metric **514** are shown in the figure, but bits and adders for second branch metric **516** are omitted in FIG. 4B for simplicity. The bits and adders for second branch metric **516** might be organized in the same structure as for first branch metric **514.** Multiplexers (labeled "M") **505, 506, 507, 508,** might select the largest sum computed using the above relation (1) (i.e., $SM = \max(BM^1 + SM^1, BM^2 + SM^2)$), and transfer the largest sum onto the respective ones of registers **509, 510, 511, 512.**

As shown in FIG. 4B, a relatively critical path of computation for ACS module **500,** is depicted in thick lines. The critical path of ACS module **500** might include 4 single-bit adders **501, 502, 503, 504** and 4 single-bit multiplexers **505, 506, 507, 508.** Thus, a depth of ACS module **500** includes 4 adders and 4 multiplexers.

However, the ACS scheme of the described embodiment shown in FIG. 2 might have a depth almost two times less than the depth of standard two 4-bit solution of ACS module **500.** These features might be achieved by using carry-save arithmetic combined with a technique of doubling of combinatorial logic of the ACS module. The carry-save arithmetic will be described below. For comparison, a ripple carry adder might be described first.

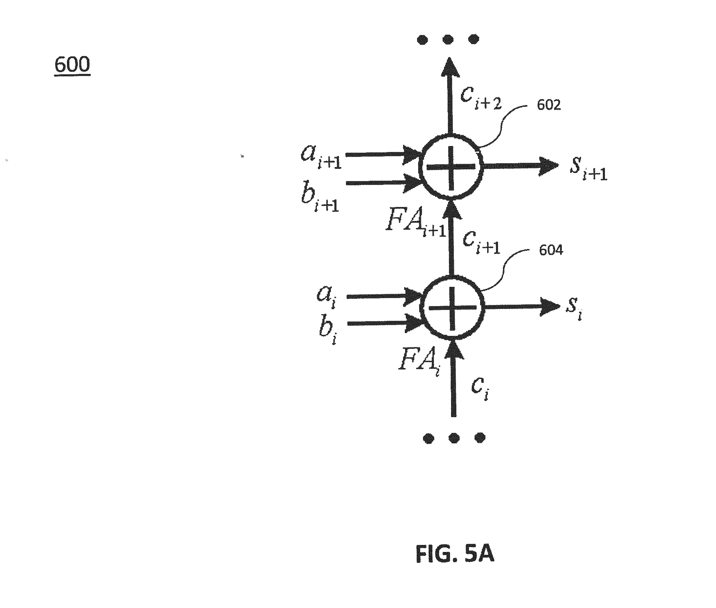

FIG. 5A is a block diagram illustrating a 2-bit ripple carry adder. Ripple carry adder **600** includes a sequence of adders and two full adders **602, 604** (also shown labeled as $FA_i$ and $FA_{i+1}$) as shown in FIG. 5A. Ripple carry adder **600** might be a logic circuit using multiple full adders to add $N$-bit numbers. As shown, $a_i$, $b_i$ are bits of numbers $A$ and

$B$, where $A = \sum_{i=0}^{n-1} a_i \, 2^i$, $B = \sum_{i=0}^{n-1} b_i \, 2^i$. Each full adder, for example, first and second fuller **602, 604,** might input a carry which is an carry output of the previous adder, and each carry bit "ripples" to the next full adder. More specifically, first and second full adders **602, 604** might receive carry inputs $c_i$ and $c_{i+1}$ from the respective preceding full adder and input bits $a_i$, $b_i$ and $a_{i+1}$, $b_{i+1}$ and provide two output bits and carry bits $s_i$, $c_{i+1}$ and $s_{i+1}$, $c_{i+2}$. First full adder **602** might receive the carry input c, from a preceding full adder. If no previous full adder exists, then the input carry $c_i$ might be zero. First full adder **602** might output the carry output $c_{i+1}$ to second full adder **604**. The carry output $c_{i+1}$ from first full adder **602** might be the carry input $c_{i+1}$ to second full adder **604**. Likewise, second full adder **604** might provide its second carry output $c_{i+2}$ as the carry input $c_{i+2}$ to the third full adder (not shown). It should be noted that the input $c_i$ might not be used to generate the $c_{i+2}$ output of the same full adder. Thus, carry propagation occurs from one full adder to the next. The respective input bits $a_i$, $b_i$ or $a_{i+1}$, $b_{i+1}$ to each of full adders **602, 604** might represent adjacent bits from four partial products. For example, first full adder **602** receives the nth bit of first, second, third and fourth partial products with second full adder **604** receiving the n+1 bits respectively of those same partial products.

First full adder **602** ($FA_i$) might compute output bit $s_i$ of the result of addition and carry bit $c_{i+1}$. The carry bit $c_{i+1}$ output from first full adder **602** might be used by following second full adder **604**. Output bit $s_i$ of the result of addition and carry bit $c_{i+1}$ bits might satisfy following relations $s_i = a_i \oplus b_i$, $c_0 = 0$, $c_{i+1} = a_i \vee b_i$, $i = 0, \dots, n\text{-}1$. Thus, the total depth of ripple carry adder **600** might equal number of bits $n$. As the number of bits increases, the depth of ripple carry adder **600** might increase, which might slow the speed of calculations.

For given implementations, the layout of ripple carry adder **600** might be relatively simple, which might allow for fast design time for the implementation; however, ripple carry adder **600** might be relatively slow, since each full adder, for example, first and second full adder **602, 604,** waits for the carry bit to be calculated from the previous full adder. The gate delay might easily be calculated from observation of the full adder circuit. Each full adder, for example, first and second adder **602, 604,** might require three levels of logic. A 32-bit ripple carry adder includes 32 full adders, so the critical path (worst case) delay might be calcualted as 3 delay-units of time (from input to carry in first adder) + 31 * 2 (for carry propagation in later adders), yielding the equivalnet of 65 gate delays.

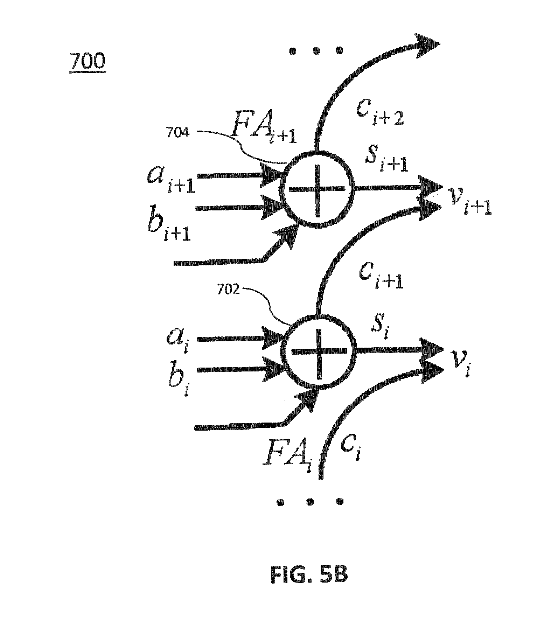

Carry-save addition techniques might be employed to reduce the depth of addition scheme shown in FIG. 5A to 1 delay-unit of time. FIG. 5B shows a block diagram illustrating a standard carry-save adder. Carry-save addition techniques might make an addition scheme perform at higher frequencies than a standard ripple carry adder. With carry-save techniques, carry bits no longer propagate through all full adders; carry bits become part of the result of the addition operation. One of the operands might be entered in carry inputs and carry outputs, instead of feeding the carry inputs of following full adders, forming a second output word which might then be added to an ordinary output in a two-operand adder to form a final sum. A carry-save adder computes the sum of three or more $n$-bit numbers in binary and outputs two numbers of the same dimensions as the inputs, one which is a sequence of partial sum bits and another which is a sequence of carry bits.

Carry-save adder **700,** as shown in FIG. 5B, allows for the rapid addition of three operands and includes a sequence of adders (only two adders **702, 704** of the sequence are shown). As shown, an addition of numbers $A$ and $B$ might satisfy relation (2):

$$A + B = \sum_{i=0}^{n-1} s_i 2^i + \sum_{i=0}^{n-1} c_i 2^i = \sum_{i=0}^{n-1} v_i 2^i, \; v_i = s_i + c_i \in \{0, 1, 2\}, i = 0, \dots, n\text{-}1, \quad (2)$$

and, as such, the result of the carry-save addition of the numbers $A$ and $B$ might be an array of carry-save bits $v_i$. Accordingly, a depth of the carry save adder might equal the depth of a single full adder, i.e., the depth might be equal to 1.

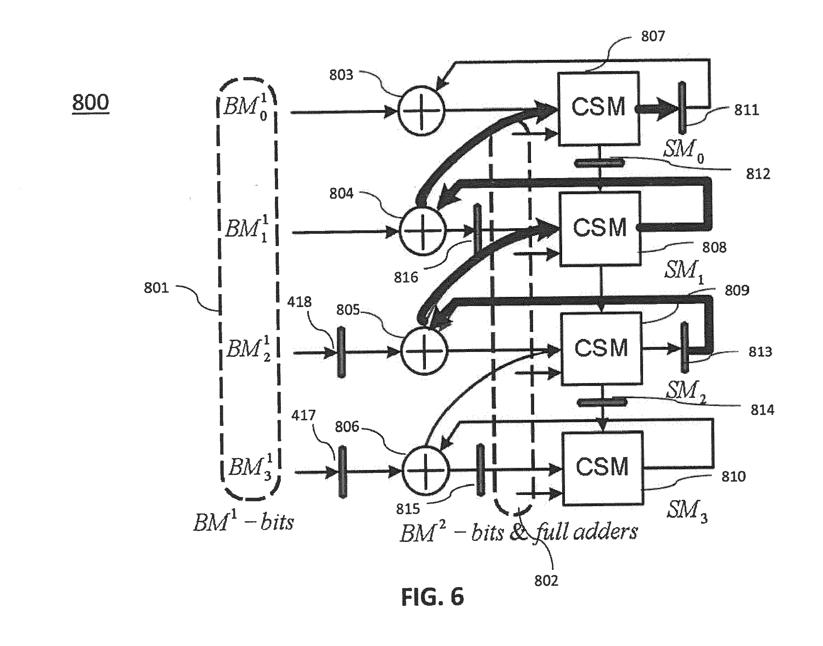

Since carry-save adders reduce the depth of the addition scheme to 1, the described embodiments applying carry-save arithmetic might increase the speed of the calculations. Referring to FIG. 6, a block diagram of a bit-level view of a carry-save ACS module of two 4-bit operands according to the present invention is illustrated. First and second ACS layers **302, 304** shown in FIG. 3 might be formed as single ACS module **800** as shown in FIG. 6. ACS module **800** includes first and second branch metrics **801, 802** represented as bit arrays, an array of adders **803, 804, 805, 806** for first branch metrics **801,** an array of compare-select multiplexers (CSMs) **807, 808, 809, 810,** and a plurality of registers **811, 812, 813, 814, 815, 816, 817, 818** for storing data. Second branch metric **802** might contain a second branch bit array and also an array of full adders which might be an exact copy of adders **803,804,805,806**. Registers **811, 812, 813, 814, 815, 816, 817, 818** might be standard registers, with respective width equal to the width of branch metrics, which might vary. For example, in some cases, 6 bits for representing a branch metric might be enough, but some decoder designs employ 8 bit representation. Bits and adders for first branch metric **801** are shown in FIG. 6, but bits and adders for second branch metric **802** are omitted in FIG. 6 for simplicity. The bits and adders for second branch metric **802** might be organized in the same structure as for branch metric **801.**

CSMs **807, 808, 809, 810** might select the largest sum computed using the relation $SM = \max (BM_1 + SM_1, BM_2 + SM_2)$, as described in FIG. 4B, and transfer the largest sum onto the respective registers **811, 812, 813, 814.**

As shown in FIG. 6, a critical path, depicted in thick lines, of ACS module **800** might include 2 single-bit adders **804, 805** and 2 single-bit CSMs **807, 808,** where carry-save arithmetic might be applied. As described above, the depth of standard ACS module **500** includes 4 adders and 4 multiplexers, whereas, ACS module **800** might include 2 single-bit adders and 2 single-bit CSMs. Thus, the ACS scheme of ACS module **800** might have a depth almost two times less than the standard solution, thereby, the ACS schemes of the described embodiments might increase the speed of the calculations. These features might be achieved by applying the carry-save arithmetic and technique of doubling of combinatorial logic of the module.

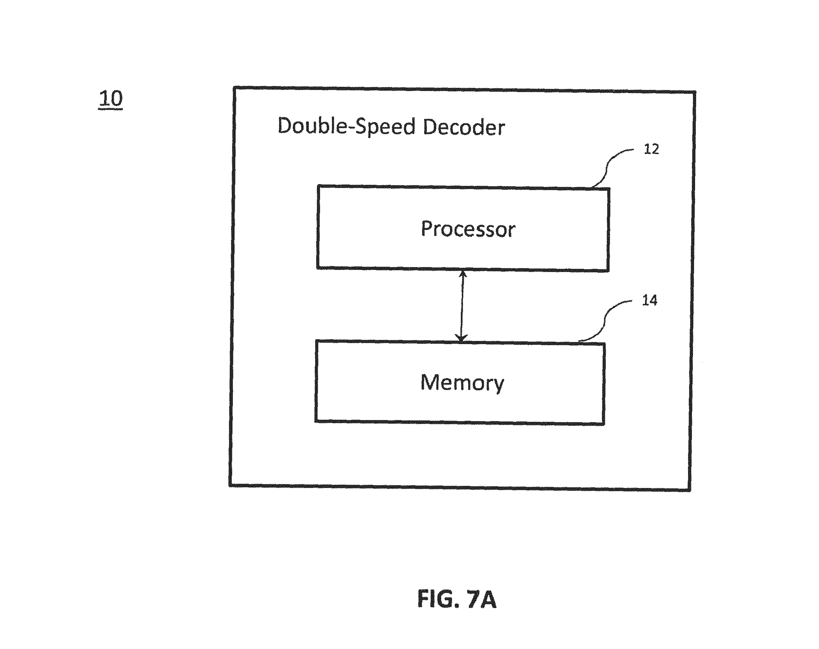

Referring to FIG. 7A, a block diagram illustrates an embodiment of a double speed ACS decoder **10** employing the double speed ACS techniques described herein in accordance with exemplary embodiments of the present invention. The decoder might be a Viterbi decoder, a turbo decoder, or a log-MAP decoder. The decoder might typically be a functional processing block in a receiver portion of a transceiver configured for use in a communications system, such as a mobile digital cellular telephone. The decoder might perform error correction functions. As shown in FIG. 7A, decoder **10** includes processor **12** and associated memory **14**. It is to be understood that the functional elements of an ACS module of the described embodiments, as described above in detail, which make up a part of a decoder, might be implemented in accordance with the decoder embodiment shown in FIG. 7A.

Processor **12** and memory **14** might preferably be part of a digital signal processor (DSP) used to implement the double speed decoder. However, it is to be understood that the term "processor" as used herein might be generally intended to include one or more processing devices and/or other processing circuitry (e.g., application-specific integrated circuits or ASICs, Gas, FPGAs, etc.). The term "memory" as used herein might be generally intended to include memory associated with the one or more processing devices and/or circuitry, such as, for example, RAM, ROM, a fixed and removable memory devices, etc. Also, in an alternative embodiment, the ACS module might be implemented in accordance with a coprocessor associated with the DSP used to implement the overall turbo decoder. In such case, the coprocessor might share in use of the memory associated with the DSP.

Accordingly, software components including instructions or code for performing the methodologies of the invention, as described herein, might be stored in the associated memory of the turbo decoder and, when ready to be utilized, loaded in part or in whole and executed by one or more of the processing devices and/or circuitry of the turbo decoder.

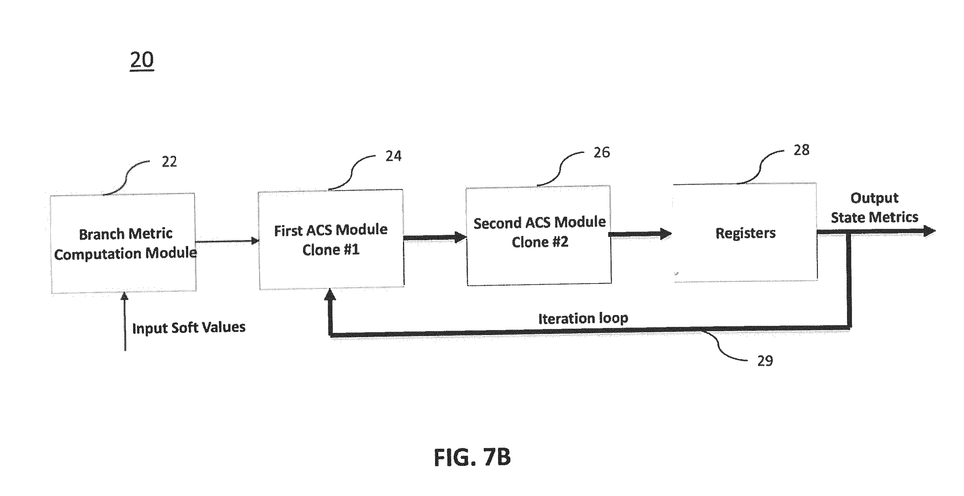

Referring to FIG. 7B, a block diagram illustrates an exemplary embodiment of a trellis-based embodiment for double speed decoder **10** applying ACS double-speed techniques in accordance with the present invention. As shown, decoder **20** includes branch metric computation module **22,** first and second ACS modules **24, 26,** and registers **28.** Branch metric computation module **22** calculates the branch metrics. First and second ACS modules **24, 26** might recursively accumulate the branch metrics as the path metrics using carry-save addition technique within iteration loop **29.** First and second ACS modules **24, 26** might then compare the incoming path metrics, and make a decision to select the most likely state transitions for each state of the trellis and generate output state metrics that might contain the corresponding decision bits. Registers **28** might store the decision bits and help to generate decoded outputs. The primary arithmetic operation performed during state metrics calculation might be ACS double-speed operation on a clock cycle, which might increase the calculation speed at least two times comparing to the conventional ACS operation.

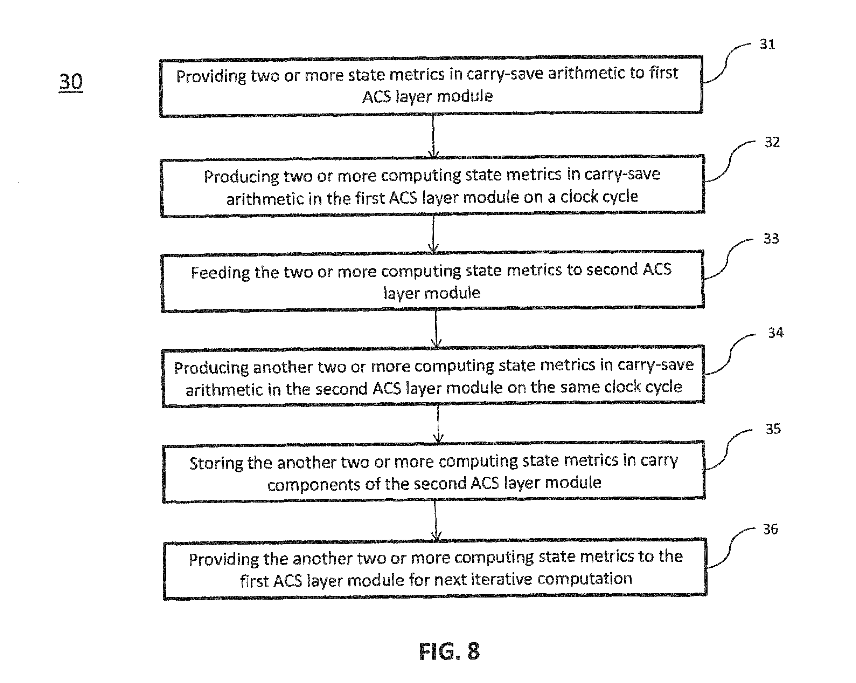

FIG. 8 is a flow chart illustrating an exemplary method for module **30** with double speed ACS techniques as shown in FIG. 3 and FIG. 6. As shown, at step **31,** two or more state metrics in carry-save arithmetic might be provided to first ACS layer module **302** that has first respective sum components. At step **32,** two or more computing state metrics in carry-save arithmetic in first ACS layer module **302** might be produced on a clock cycle in response to two or more respective branch metrics. At step **33,** the two or more computing state metrics might be fed to second ACS layer module **304** that has second respective sum and carry components. At step **34,** another two or more computing state metrics in carry-save arithmetic in second ACS layer module **304** might be produced in response to another two or more respective branch metrics and the two or more computing state metrics on the same clock cycle. At step **35,** the another two or more computing state metrics might be stored in carry components **306** of second ACS layer module **304.** At step **36,** the another two or more computing state metrics might be provided to first ACS layer module **302** for next iterative computation.

Reference herein to "one embodiment" or "an embodiment" means that a particular feature, structure, or characteristic described in connection with the embodiment can be included in at least one embodiment of the invention. The appearances of the phrase "in one embodiment" in various places in the specification are not necessarily all referring to the same embodiment, nor are separate or alternative embodiments necessarily mutually exclusive of other embodiments. The same applies to the term "implementation."

As used in this application, the word "exemplary" is used herein to mean serving as an example, instance, or illustration. Any aspect or design described herein as "exemplary" is not necessarily to be construed as preferred or advantageous over other aspects or designs. Rather, use of the word exemplary is intended to present concepts in a concrete fashion.

Additionally, the term "or" is intended to mean an inclusive "or" rather than an exclusive "or". That is, unless specified otherwise, or clear from context, "X employs A or B" is intended to mean any of the natural inclusive permutations. That is, if X employs A; X employs B; or X employs both A and B, then "X employs A or B" is satisfied under any of the foregoing instances. In addition, the articles "a" and "an" as used in this application and the appended claims should generally be construed to mean "one or more" unless specified otherwise or clear from context to be directed to a singular form.

Although the subject matter described herein may be described in the context of illustrative implementations to process one or more computing application features/operations for a computing application having user-interactive components the subject matter is not limited to these particular embodiments. Rather, the techniques described herein can be applied to any suitable type of user-interactive component execution management methods, systems, platforms, and/or apparatus.

The present invention may be implemented as circuit-based processes, including possible implementation as a single integrated circuit (such as an ASIC or an FPGA), a multi-chip module, a single card, or a multi-card circuit pack. As would be apparent to one skilled in the art, various functions of circuit elements may also be implemented as processing blocks in a software program. Such software may be employed in, for example, a digital signal processor, micro-controller, or general-purpose computer.

The present invention can be embodied in the form of methods and apparatuses for practicing those methods. The present invention can also be embodied in the form of program code embodied in tangible media, such as magnetic recording media, optical recording media, solid state memory, floppy diskettes, CD-ROMs, hard drives, or any other machine-readable storage medium, wherein, when the program code is loaded into and executed by a machine, such as a computer, the machine becomes an apparatus for practicing the invention. The present invention can also be embodied in the form of program code, for example, whether stored in a storage medium, loaded into and/or executed by a machine, or transmitted over some transmission medium or carrier, such as over electrical wiring or cabling, through fiber optics, or via electromagnetic radiation, wherein, when the program code is loaded into and executed by a machine, such as a computer, the machine becomes an apparatus for practicing the invention. When implemented on a general-purpose processor, the program code segments combine with the processor to provide a unique device that operates analogously to specific logic circuits. The present invention can also be embodied in the form of a bitstream or other sequence of signal values electrically or optically transmitted through a medium, stored magnetic-field variations in a magnetic recording medium, etc., generated using a method and/or an apparatus of the present invention.

The use of figure numbers and/or figure reference labels in the claims is intended to identify one or more possible embodiments of the claimed subject matter in order to facilitate the interpretation of the claims. Such use is not to be construed as necessarily limiting the scope of those claims to the embodiments shown in the corresponding figures.

It should be understood that the steps of the exemplary methods set forth herein are not necessarily required to be performed in the order described, and the order of the steps of such methods should be understood to be merely exemplary. Likewise, additional steps may be included in such methods, and certain steps may be omitted or combined, in methods consistent with various embodiments of the present invention.

Although the elements in the following method claims, if any, are recited in a particular sequence with corresponding labeling, unless the claim recitations otherwise imply a particular sequence for implementing some or all of those elements, those elements are not necessarily intended to be limited to being implemented in that particular sequence.

No claim element herein is to be construed under the provisions of 35 U.S.C. § 112, sixth paragraph, unless the element is expressly recited using the phrase "means for" or "step for."

It will be further understood that various changes in the details, materials, and arrangements of the parts which have been described and illustrated in order to explain the nature of this invention may be made by those skilled in the art without departing from the scope of the invention as expressed in the following claims.

**Claims**

1. A method of iteratively performing an add-compare-selection, ACS, operation, the method comprising, for an iteration:

   providing at least two state metrics with carry-save arithmetic to a first ACS layer module having first respective sum components;
   producing, by the first ACS layer module, a first set of at least two computing state metrics in carry-save arithmetic in response to a first set of at least two respective branch metrics in a single clock cycle;

applying the first set of at least two computing state metrics to a second ACS layer module having second respective sum and carry components;

producing, by the second ACS layer module, a second set of at least two computing state metrics in carry-save arithmetic in response to a second set of at least two respective branch metrics and the first set of at least two computing state metrics in the clock cycle;

storing the second set of at least another two computing state metrics as carry components of the second ACS layer module; and

providing the second set of at least two computing state metrics to the first ACS layer module for a next iteration.

2. The method of claim 1, wherein, for the storing, the carry components are stored in registers.

3. An method for performing an add-compare-select, ACS, operation comprising:

at least two ACS layers coupled in series configured to form an iterative loop with carry components in a single clock cycle,
wherein the ACS layer includes at least two branch metrics represented by a plurality of bits and adders and configured to i) generate a plurality of state metrics in accordance with carry-save arithmetic, and a plurality of multiplexers and ii) perform a selection of a maximum state metric in carry-save arithmetic which are stored in the carry components.

4. The method of claim 3, wherein the carry components are stored in corresponding registers.

5. The method of claim 3, wherein the ACS module is configured to perform an ACS operation of four operands (ACS4).

6. The method of claim 3, wherein the ACS module is configured to perform an ACS operation of eight operands (ACS8).

7. The method of claim 3, wherein the ACS module is configured to perform an ACS operation of sixteen operands (ACS16).

8. An apparatus for performing an add-compare-select, ACS, operation comprising:

at least two layers of an ACS module configured to perform state metric computations using carry-save arithmetic, each having corresponding input and output states and corresponding input and output vectors; and
carry components of stored state metrics,
wherein the output state of a preceding layer of the ACS module is provided to a subsequent layer of the ACS module having an input vector different from the input vector of the preceding layer of the ACS module, the apparatus configured to form a ACS layer computing in a single clock cycle to generate at least a maximum state metric in carry-save arithmetic.

9. The apparatus of claim 8, wherein the carry components are stored in corresponding registers.

10. The apparatus of claim 8, wherein the ACS module is configured to perform an ACS operation of four operands (ACS4).

11. The apparatus of claim 8, wherein the ACS module is configured to perform an ACS operation of eight operands (ACS8).

12. The apparatus of claim 8, wherein the ACS module is configured to perform an ACS operation of sixteen operands (ACS16).

13. A trellis decoder comprising:

a memory including a set of registers; and
an add-compare-select (ACS) module including:
at least two ACS layer modules coupled in series and configured to form a feedback loop with carry components in a single clock cycle, wherein the ACS layer module includes at least two branch metrics represented by a plurality of bits and adders configured to generate a plurality of state metrics using carry-save arithmetic, and a plurality of multiplexers configured to perform a selection of a maximum state metric in carry-save arithmetic stored in memory as the carry components.

100

(Prior Art)

**FIG. 1**

200

202

$x(t)$

$y(t)$

ACS Layer Combinatorial Gates

$q(t+1)$

$q(t)$

204

FIG. 2

FIG. 3

**FIG. 4A**

FIG. 4B

FIG. 5A

FIG. 5B

**FIG. 6**

EP 2 797 237 A1

10

## Double-Speed Decoder

Processor  12

Memory  14

**FIG. 7A**

EP 2 797 237 A1

FIG. 7B

EP 2 797 237 A1

30

Providing two or more state metrics in carry-save arithmetic to first ACS layer module — 31

Producing two or more computing state metrics in carry-save arithmetic in the first ACS layer module on a clock cycle — 32

Feeding the two or more computing state metrics to second ACS layer module — 33

Producing another two or more computing state metrics in carry-save arithmetic in the second ACS layer module on the same clock cycle — 34

Storing the another two or more computing state metrics in carry components of the second ACS layer module — 35

Providing the another two or more computing state metrics to the first ACS layer module for next iterative computation — 36

FIG. 8

**Europäisches Patentamt**
**European Patent Office**
**Office européen des brevets**

# EUROPEAN SEARCH REPORT

Application Number

EP 13 18 7211

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KR 2010 0112221 A (UNIV SEJONG IND ACAD COOP GR [KR]) 19 October 2010 (2010-10-19) <br> * paragraph [0022]; figure 4 * <br> * paragraph [0030] - paragraph [0031]; figure 5 * <br> * paragraph [0046] - paragraph [0047]; figures 8a, 8b * <br> * paragraph [0051] - paragraph [0053]; figure 9 * | 1-13 | INV. <br> H03M13/39 <br> H03M13/41 <br> H03M13/00 |
| A | FETTWEIS G ET AL: "A 100MBIT/S VITERBI DECODER CHIP:NOVEL ARCHITECTURE AND ITS REALIZATION", INTERNATIONAL CONFERENCE ON COMMUNICATIONS. INCLUDING SUPERCOMM TECHNICAL SESSIONS. ATLANTA, APR. 15 - 19, 1990; [INTERNATIONAL CONFERENCE ON COMMUNICATIONS], NEW YORK, IEEE, US, vol. 2 OF 04, 15 April 1990 (1990-04-15), pages 463-467, XP000146110, * Section 3.2; figure 7 * <br> * Section 5.1 * | 1-13 | |
| A | US 2009/089556 A1 (LEE SEOK-JUN [US] ET AL) 2 April 2009 (2009-04-02) <br> * the whole document * <br> * paragraph [0049]; figure 7 * | 1-13 | TECHNICAL FIELDS SEARCHED (IPC) <br><br> H03M |
| A | US 2004/158542 A1 (BRULS NIKOLAUS [US]) 12 August 2004 (2004-08-12) <br> * the whole document * | 1-13 | |

-/--

The present search report has been drawn up for all claims

| Place of search | Date of completion of the search | Examiner |
|---|---|---|
| Munich | 18 November 2013 | Farman, Thomas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 13 18 7211

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | YEO E ET AL: "A 500-MB/S SOFT-OUTPUT VITERBI DECODER", IEEE JOURNAL OF SOLID-STATE CIRCUITS, vol. 38, no. 7, July 2003 (2003-07), pages 1234-1241, XP001169609, ISSN: 0018-9200, DOI: 10.1109/JSSC.2003.813250 * the whole document * ----- | 1-13 | |
| | | | TECHNICAL FIELDS SEARCHED (IPC) |

The present search report has been drawn up for all claims

| Place of search | Date of completion of the search | Examiner |
|---|---|---|
| Munich | 18 November 2013 | Farman, Thomas |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
 
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 13 18 7211

This annex lists the patent family members relating to the patent documents cited in the above-mentioned European search report.
The members are as contained in the European Patent Office EDP file on
The European Patent Office is in no way liable for these particulars which are merely given for the purpose of information.

18-11-2013

| Patent document cited in search report | Publication date | Patent family member(s) | | Publication date |
|---|---|---|---|---|
| KR 20100112221 A | 19-10-2010 | NONE | | |
| US 2009089556 A1 | 02-04-2009 | NONE | | |
| US 2004158542 A1 | 12-08-2004 | CN | 1512673 A | 14-07-2004 |
| | | DE | 10255426 B3 | 18-03-2004 |
| | | US | 2004158542 A1 | 12-08-2004 |

EPO FORM P0459

For more details about this annex : see Official Journal of the European Patent Office, No. 12/82